Europäisches Patentamt

European Patent Office

Office européen des brevets

(19)

(11) Numéro de publication: **0 197 990**

**B1**

(12) **FASCICULE DE BREVET EUROPÉEN**

(45) Date de publication du fascicule du brevet:
**19.04.89**

(21) Numéro de dépôt: **85904980.1**

(22) Date de dépôt: **09.10.85**

(86) Numéro de dépôt international:
**PCT/FR 85/00283**

(87) Numéro de publication internationale:
**WO 86/02386 (24.04.86 Gazette 86/09)**

(51) Int. Cl.⁴: **C 23 C 14/08,** H 01 L 21/316,
H 01 G 4/10

(54) PROCEDE DE FORMATION PAR DEPOT SOUS BASSE PRESSION D'UNE COUCHE DE MATERIAU ISOLANT SUR UN SUBSTRAT ET PRODUIT OBTENU.

(30) Priorité: **09.10.84 FR 8415573**

(43) Date de publication de la demande:
**22.10.86 Bulletin 86/43**

(45) Mention de la délivrance du brevet:
**19.04.89 Bulletin 89/16**

(84) Etats contractants désignés:
**AT BE CH DE FR GB IT LI LU NL SE**

(56) Documents cité:
**DE-B-1 002 584**
**DE-B-1 065 689**
**DE-B-1 225 939**
**GB-A-930 220**
**US-A-3 184 329**
**US-A-3 201 667**
**US-A-3 463 974**
**US-A-3 617 375**

Patents Abstracts of Japan, vol. 7, no. 175-(C-179)(1320) 3 August 1983 & JP A 5881967 (Nippon Denshin Denwa Kosha) 17 May 1983
Patents Abstracts of Japan, vol. 4, no. 106(c-20)(588), 30 July 1980, page 7 C 20 & JP A 5565358 (Nippon Kougaku Kogyo K.K.) 16 May 1980
IEEE Technical Digest, 1974, International Electron Devices Meeting, 9, 10, 11 December 1974, Washington, DC. IEEE (New York, US). R. Singh et

(73) Titulaire: **Etablissement Public dit: CENTRE NATIONAL DE LA RECHERCHE SCIENTIFIQUE (CNRS), 15, Quai Anatole France, F-75007 Paris (FR)**

(72) Inventeur: **BLANCHET, Robert, 82, avenue de la Poterie, F-69890 La Tour de Salvagny (FR)**
Inventeur: **SANTINELLI, Claude, 254 Les Erables - Le Plateau, La Duchere F-69009 Lyon (FR)**

(74) Mandataire: **Ropital- Bonvarlet, Claude, Cabinet BEAU DE LOMENIE 99, Grande rue de la Guillotière, F-69007 Lyon (FR)**

(56) Documents cité: (suite)
al.: "New method of passivating GaAs with A12 03", pages 576-578, see page 577, left hand column, paragraph 2

Le dossier contient des informations techniques présentées postérieurement au dépôt de la demande et ne figurant pas dans le présent fascicule.

## Description

### Domaine technique:

L'invention concerne la fabrication de composants électroniques.

La présente invention concerne la technique de dépôt, sous basse pression, d'un matériau sur un substrat donné et elle vise, plus particulièrement, le dépôt ou la constitution, notamment par évaporation, d'une couche d'un matériau isolant sur un support nu ou déjà revêtu, par des procédés divers, de couches ou de films de matériaux conducteurs ou semi-conducteurs.

Le domaine technique concerné est celui de la fabrication des composants électroniques.

### Art antérieur:

Pour former, par exemple, sous vide ou ultra-vide, sur un substrat, une couche d'un matériau isolant, l'art antérieur connu propose deux techniques principales qui ont, toutes deux, l'avantage de ne pas nécessiter un chauffage du composant en cours de fabrication à une température telle, par exemple de l'ordre de 1 000 °C, que les caractéristiques initiales du composant soient dégradées sous l'influence d'une redif fusion des impuretés dopantes ou d'une décomposition partielle du semi-conducteur.

L'une de ces techniques consiste à assurer l'arrivée, sur le substrat, de particules de matière (atomes ou molécules) activées en énergie et qui sont, en quelque sorte, amenées par bombardement à s'implanter et s'organiser chimiquement, de manière à former une couche sensiblement homogène, présentant de bonnes caractéristiques de résistivité.

Cette technique n'est, toutefois, pas satisfaisante dans le domaine d'application, car les particules activées en énergie se conduisent comme des projectiles par rapport à la surface et à la sous-couche de la face à revêtir du substrat. Il en résulte une destruction partielle et une perturbation du réseau cristallin qui sont, la plupart du temps, incompatibles avec le domaine d'application, étant donné que la sous-couche exposée du substrat représente un élément qui est actif au cours du fonctionnement physique électronique. La destruction et/ou la perturbation de la surface et de la sous-couche viennent modifier considérablement les caractéristiques électroniques, de sorte que le produit final obtenu ne présente plus les caractéristiques qui auraient dû, normalement, lui être conférées.

Cette technique, qualifiée de dure, ne peut souvent pas être mise en oeuvre dans le domaine d'application pour la fabrication de composants électroniques en tant que tels, ou même pour la passivation de surface de tels composants.

La seconde technique, dite douce par opposition à la précédente, consiste à assurer la formation d'une couche de matériau isolant par dépôt par évaporation sous vide, c'est-à-dire en assurant le transfert d'atomes ou de molécules, uniquement par l'énergie associée à l'évaporation sous vide, sans que ces particules soient autrement activées.

Dans cette technique, plusieurs méthodes sont, généralement, réconisées.

L'une d'elles peut être qualifée d'évaporation thermique par effet Joule. Cette technique consiste à faire le vide dans une enceinte, voire l'ultra-vide, et à chauffer une réserve de matériau, de manière à provoquer son évaporation en direction d'un substrat exposé. Une telle technique est, par exemple, généralement, utilisée pour l'oxyde simple de silicium (SiO).

Une telle méthode douce présente l'avantage d'assurer un transfert de particules non activées qui ne perturbent pas ou ne détruisent pas la surface ou la sous-couche du support. En revanche, l'absence d'énergie de ces particules est responsable d'un mauvais accrochage entre elles et d'une organisation structurelle défectueuse.

Selon cette méthode, le chauffage de la réserve de matière peut aussi avoir pour effet de décomposer certaines des molecules évaporées et, par suite, de donner lieu à la formation d'une couche non stoechiométrique.

L'absence d'énergie initiale n'est pas favorable, non plus, à un bon accrochage sur la surface du substrat et rend, en outre, la couche sensible aux impuretés présentes sur la surface du substrat ou produites lors de l'évaporation du matériau de base par le chauffage de son support, tel qu'un creuset réalisé en une matière différente du matériau à évaporer.

Une telle méthode n'est, généralement, envisageable que pour des matériaux s'évaporant à des températures basses, de l'ordre de 900 à 1 000°C et qui sont donc d'une nature instable. Cette instabilité conduit à des défauts de composition associés à une résistivité insuffisante pour l'application visée.

On conçoit qu'une telle méthode ne permet donc pas d'obtenir des couches isolantes de caractéristiques reproductibles.

Une seconde méthode, voisine de la première, consiste à assurer l'évaporation sous vide ou ultra-vide du matériau de base en le chauffant par un canon à électrons. Cette méthode permet de ne chauffer que le matériau de base et supprime, en conséquence, l'évaporation d'impuretés en provenance de la matière constitutive du creuset. Il devient ainsi possible d'évaporer des matériaux présentant de plus grandes qualités réfractaires et s'évaporant, par conséquent, à plus haute température que dans le cas de la méthode

2

précédente.

Il faut noter, parmi les avantages de cette méthode, que la montée en température par un canon à électrons permet d'élever sensiblement cette température et, par exemple, de monter à 1 400°C on plus, en vue de provoquer l'évaporation directement d'un matériau isolant, tel que l'alumine, connu pour ses bonnes caractéristiques de résistivité.

Cependant, les atomes ou molécules évaporés sont, également, peu énergétiques, de sorte que, globalement, les mêmes inconvénients que les méthodes décrites plus haut sont aussi à rattacher au produit obtenu selon cette méthode.

En outre, l'énergie appliquée par le canon à électrons peut provoquer une projection de gouttelettes du matériau non évaporé sur la couche en cours de croissance et une décomposition partielle des molécules évaporées. Ces deux phénoménes affectent alors les caractéristiques de la couche.

En plus des inconvénients ci-dessus, il faut noter qu'un canon à électrons représente un matériel lourd, cher et difficile à régler, de sorte que le coût de réalisation d'une couche isolante est sensiblement plus élevé qu'avec la méthode précédente.

Il faut noter, de façon supplémentaire, que la mise en oeuvre d'un canon à électrons permet difficilement de descendre à des vitesses d'évaporation faibles, étant donné qu'il est nécessaire de développer une énergie suffisante pour assurer la montée en température du matériau de base.

Une troisième méthode peut être qualifiée d'évaporation thermique sous vide réactive, faisant intervenir ou non un canon à électrons pour assurer la montée en température du matériau de base. Selon cette méthode, l'évaporation du matériau se déroule dans une atmosphère de gaz réactif, généralement de l'oxygène, qui a pour effet d'assurer l'oxydation des atomes ou molécules évaporés.

Cette méthode permet d'utiliser des matériaux plus faciles à évaporer et exigeant moins de puissance et moins de chauffage et de produire, par exemple à partir de l'aluminium, des atomes ou molécules se transformant en alumine par oxydation pendant le déroulement du processus.

Si une telle méthode apparaît plus satisfaisante que les deux précédentes mentionnées, en revanche, on constate que les couches de matériau isolant déposé n'ont pas de bonnes caractéristiques reproductibles, toujours en raison du caractère inhomogène et de défauts stoechiométriques de la couche, dus à la faible énergie des atomes ou molécules transférés.

Il convtent de citer, également, l'enseignement fourni par la demande DE-B-1 225 939 et selon lequel on produit une couche d'un matériau isolant sur un substrat par évaporation sous vide. Le procédé préconisé prévoit une évaporation sous vide relatif d'environ $10^{-1}$ Pa pour produire un dépôt, puis, ensuite, l'introduction d'un gaz dans l'enceinte pour remonter la pression, enfin l'application d'une décharge électrique, ces différentes étapes étant successivement recommencées jusqu'à atteindre l'épaisseur de couche désirée.

Des études, menées sur ces méthodes, ont permis de constater que la couche de matériau obtenue présentait, néanmoins, de bonnes caractéristiques mécaniques et se trouvait convenablement associée ou accrochée au substrat.

Les mauvaises ou médiocres caractéristiques électriques présentées par de telles couches semblent pouvoir être mises au compte de la mauvaise organisation physique des premiers atomes ou molécules déposés. Ceci a été corroboré par des tests et essais qui ont permis de déceler que, par les méthodes ci-dessus, appartenant à la technique douce, il était parfois possible d'obtenir des couches isolantes ayant des caractéristiques de résistivité acceptables, alors que le matériau de base, le substrat et les paramètres ou conditions opératoires étaient identiques.

C'est en partant de cette constatation que le Demandeur a développé un nouveau procédé de formation sous basse pression d'une couche de matériau isolant sur un substrat, procédé conçu pour supprimer tout aléa d'accrochage intime et de bonne cohésion, homogénéité et stoechiométrie de la couche isolante déposée, au moins dans sa partie adjacente et susjacente à la surface du support à recouvrir.

## Exposé de l'invention:

Le procédé de l'invention a pour objectif de fournir une méthode opératoire permettant de réaliser le dépôt d'une couche de matériau isolant sur un support quelconque, une telle couche pouvant être réalisée de façon reproductible pour présenter de bonnes caractéristiques de mesure de résistivité, de constante diélectrique et de rigidité diélectrique, en vue de fournir, de manière rapide, peu chère et constante, des produits fiables utilisables dans le domaine d'application de l'électronique et, plus particulièrement, de la micro-électronique.

Pour atteindre les buts ci-dessus, le procédé de l'invention est caractérisé par les étapes successives selon la revendication 1.

Diverses autres caractéristiques ressortent des revendication 2 à 9 de la description ci-dessous faite en référence aux dessins annexés qui montrent, à titre d'exemples non limitatifs, des formes de réalisation de l'objet de l'invention.

# EP 0 197 990 B1

## Brève description des dessins:

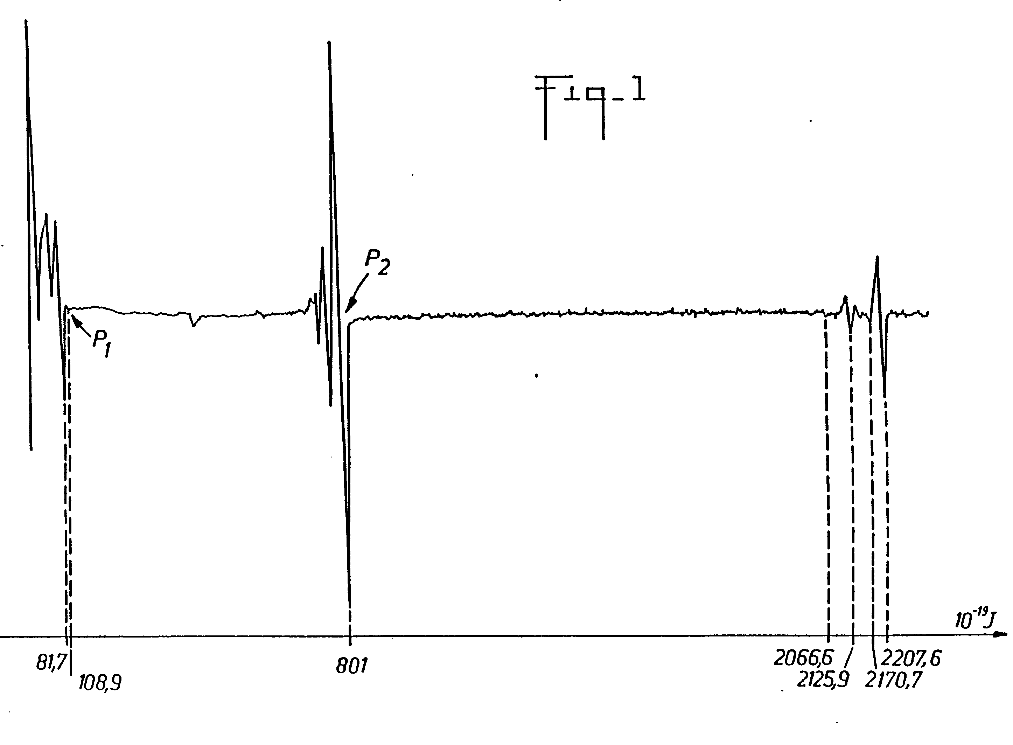

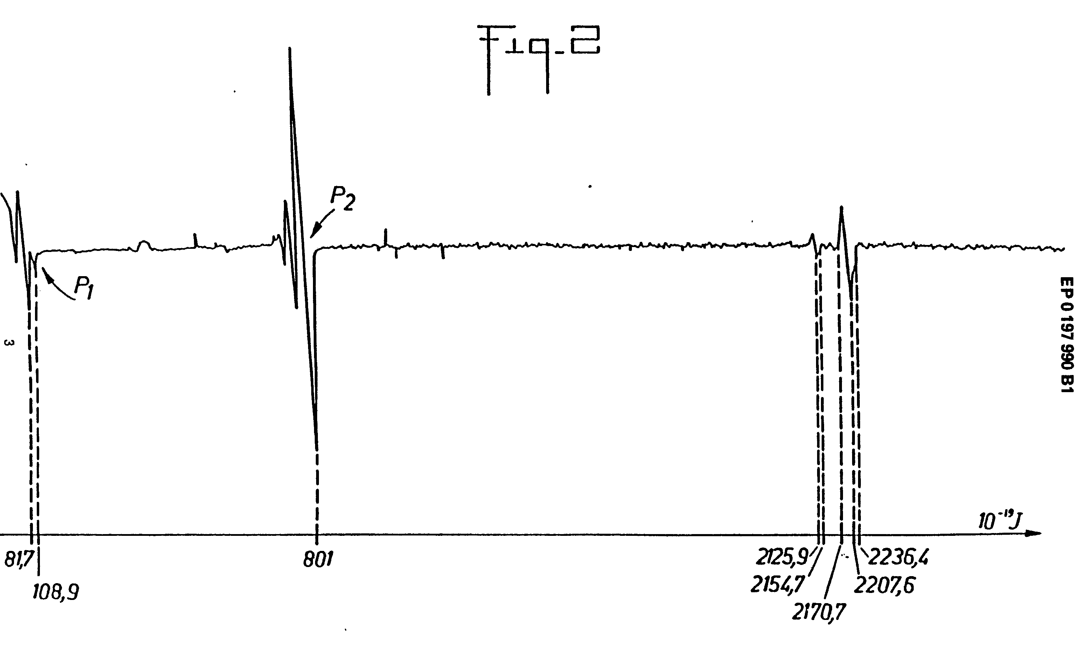

Les fig. 1 et 2 sont deux courbes illustrant certaines caractéristiques d'une couche isolante formée selon le procédé de l'invention et d'une couche isolante formée selon les méthodes traditionnelles.

## Meilleure manière de réaliser l'invention:

Pour mettre en oeuvre le procédé de l'invention, selon un exemple de formation par évaporation sous vide, il est fait appel à une enceinte associée à des moyens capables de faire et d'entretenir à l'intérieur de cette dernière un vide relatif. Une telle enceinte, bien connue dans la technique, n'est ni décrite en détail, ni illustrée dans ce qui suit, car sa structure n'est pas directement modifiée par le procédé de l'invention.

Pour mémoire, il est rappelé qu'une telle enceinte comporte, généralement, des moyens permettant d'assurer l'introduction et le support d'au moins un substrat, des moyens de maintien d'au moins un creuset ou analogue supportant le matériau à évaporer, un hublot d'examen visuel, des moyens de contrôle du déroulement du procédé, des moyens de chauffage soit par apport thermique, soit par mise en oeuvre d'un canon à électrons, d'un canon à ions, des moyens de support et de commande d'au moins un écran entre le substrat et la source d'évaporation, ainsi que des moyens d'introduction d'un fluide gazeux.

Le procédé de l'invention fait, également, intervenir un processus opératoire de mise en oeuvre d'une telle enceinte pouvant être considéré, dans ses grandes lignes, comme connu. Un tel procédé comprend, notamment, le chargement du creuset, le montage du substrat, la création d'un vide relatif dans l'enceinte et le chauffage du matériau à évaporer.

Selon l'invention, il est prévu de créer et d'entretenir initialement un vide relatif à partir de $10^{-3}$ Pa et, par exemple, compris entre $10^{-5}$ et $10^{-9}$ Pa. On crée ensuite, à l'intérieur de l'enceinte, une pression partielle par introduction d'un gaz ayant des propriétés d'oxydation du matériau à évaporer. Cette pression partielle est au moins supérieure d'une décade au vide initial. Elle est, par exemple, établie à $10^{-3}$ Pa par introduction d'oxygène dans l'enceinte.

En plus de ces conditions, la montée en température du matériau à évaporer est assurée de manière à provoquer son évaporation sous vide au sein du milieu oxydant et son transfert, au moins partiel, en direction de la surface exposée.

Selon un exemple de mise en oeuvre du procédé, s'agissant d'assurer l'évaporation d'aluminium, on assure la montée en température du creuset jusqu'à environ 1 100°C. Pour le déroulement du procédé selon l'invention, le substrat peut être maintenu à une température comprise entre l'ambiante et 450°C.

Sur la base de telles conditions opératoires, on réalise l'évaporation sous pression partielle d'oxygène de l'aluminium, de manière à former sur la surface du substrat une pré-couche de matériau isolant comprise entre 1 et 5 nanomètres. Lorsque cette épaisseur a été atteinte, on interpose, entre le substrat et la source d'évaporation que constitue la réserve de matériau de base, un masque, disposé de manière ii s'opposer au transfert des atomes ou molécules évaporées en direction de la surface exposée.

On laisse alors séjourner le substrat et la pré-couche qu'il porte dans le milieu oxydant, avec maintien des autres paramètres de conduite du processus pendant au moins quelques minutes. Ce maintien en milieu oxydant tend à rendre parfaite l'oxydation des atomes ou molécules déjà transférés. Il en résulte, au moins sur une partie de la pré-couche, une meilleure homogénéité chimique conférant à cette partie de la pré-couche de bonnes caractéristiques stoechiométriques.

On retire ensuite le masque, de manière que, les différents paramètres étant toujours les mêmes, le processus de constitution d'une couche puisse de nouveau se dérouler à partir de la pré-couche.

On peut ainsi, sur la base des conditions opératoires ci-dessus, procéder par exemple à la formation par dépôt par évaporation d'une couche de 100 nanomètres à raison de 100 nm/h en faisant intervenir une pression partielle du milieu oxydant de 1,3. $10^3$ Pa et une température de creuset sensiblement équivalente à 1 100°C.

La couche définitive de matériau isolant ainsi obtenue présente alors une bonne tenue mécanique par elle-même, des caractéristiques d'accrochage ferme sur le substrat et des caractéristiques de résistivité, reproductibles d'un substrat à un autre, nettement améliorées et constantes par rapport aux techniques antérieures et pouvant être couramment superieures à $10^{11}$ ohms.m et même de l'ordre de $10^{12}$ ohms.m.

Selon une phase opératoire de l'invention, il peut être procédé à un contrôle de la pré-couche, afin de déterminer, par tout moyen convenable à cet égard, l'existence éventuelle dans l'espèce évaporée d'atomes chimiquement libres.

A titre d'exemple, il est possible de procéder à un tel contrôle par spectrométrie d'électrons AUGER conduite après la phase de maintien ou de séjour de la pré-couche dans le milieu oxydant, c'est-à-dire après l'interposition du masque. Une telle méthode de contrôle permet de mettre en évidence, comme cela est illustré par la fig. 1, une courbe se caractérisant par l'absence ou l'extrême petitesse du pic, associé à l'énergie caractéristique de l'aluminium libre $108,9.10^{-19}$ J, $P_1$ et la grande proportion du pic oxygène en $P_2$, par comparaison avec la courbe illustrée par la fig. 2, correspondant à une couche de matériau isolant formée à partir d'aluminium ou d'alumine selon l'une quelconque des méthodes de la technique douce antérieure.

La comparaison de ces deux courbes permet de faire apparaître, de façon manifeste, en considération de la fig. 1, que la pré-couche formée selon le procédé de l'invention est exempte d'atomes ou particules aluminium

4

chimiquement libres et inclut une grade proportion d'oxygène proche de la proportion stoechiométrique, ces deux traits, distinctifs de la courbe par rapport à ceux fournis par la technique antérieure, étant caractéristiques de la mise en oeuvre du procédé. Un ensemble d'autres traits distinctifs associé aux pics haute énergie ressort, également, de la comparaison des fig. 1 et 2. Il s'agit tout d'abord du pic 2 066,6.10$^{-19}$ J caractéristique de l'alumine présent sur la fig. 1 et pratiquement absent sur la fig. 2, ensuite de la forme caractéristique de la courbe entre les énergies 2 125,9. 10$^{-19}$ et J et 2 170,7.10$^{-19}$ J, puis de l'absence des renflements ou de dédoublements aux énergies 2 154,7.10$^{-19}$ J et 2 236,4.10$^{-19}$ J visibles sur la fig. 2.

Le procédé de contrôle ci-dessus fournit des indications représentatives, dans la mesure où la surface du matériau isolant ne s'est pas modifiée par un séjour prolongé sous vide en l'absence de pression partielle d'oxygène. Dans un tel cas, il est necessaire d'éliminer la zone perturbée au voisinage de la surface par érosion ionique.

Si la courbe obtenue fait apparaître l'existence d'un pic aluminium libre en P$_1$ d'énergie 108,9.10$^{-19}$, le procédé de l'invention consiste à accroître la durée de séjour ou de maintien de la pré-couche dans le milieu oxydant, afin de parfaire l'oxydation de l'espèce évaporée.

Il est possible, également, selon une variante du procédé de l'invention, de recommencer la procédure opératoire précédente, de façon à former, dans des conditions équivalentes ou voisines, par dépôt par évaporation sous vide, voire ultra-vide, une seconde pré-couche recouvrant la première et qui est, comme la précédente, maintenue dans le milieu oxydant après interposition du masque protecteur.

Pour parfaire l'oxydation de la pré-couche, il est possible aussi, selon l'invention, de faire intervenir, indépendamment ou en association avec le séjour de la pré-couche dans le milieu oxydant, une phase d'oxydation active par un bombardement de la précouche par le flux ou faisceau d'un canon à ions inclus dans l'enceinte. Après introduction d'oxygène dans l'enceinte, un tel canon permet de bombarder la pré-couche avec des ions oxygène pouvant être animés d'une énergie de quelques électrons-volts à quelques milliers d'électrons-volts. L'impact de ces ions sur la pré-couche assure un apport d'énergie à toutes les molécules leur conférant un gain de cohésion, de densité et d'homogénéité, tout en assurant la liaison par oxydation.

Cette phase du procédé peut, par exemple, faire intervenir un canon à ions d'une énergie de 800.10$^{-19}$ J, c'est-à-dire un canon pouvant être considéré comme classique dans le domaine industriel et susceptible d'être utilisé à moindre coût.

Les paramètres caractéristiques du bombardement de la pré-couche sont choisis en fonction de l'épaisseur de cette dernière, de manière que l'effet d'érosion qui en découle laisse subsister une partie de la pré-couche afin que la surface du substrat reste protégée contre les ions. Cette partie est, par axemple, au moins égale à 0,5 nm et, de préférence, égale à la moitié de l'épaisseur de la pré-couche.

Dans le cas de formation d'une couche d'une épaisseur de 5 nm, un canon à ions d'une puissance de 800.10$^{-19}$ J est mis en oeuvre pendant quelques minutes.

Le processus de formation de la couche est ensuite conduit, comme dit précédemment.

Il doit être considéré que la conduite du procédé selon l'invention peut être menée à bien pour ce qui concerne la montée en température du matériau de base en faisant intervenir tous les moyens classiques à cet égard. Ainsi, la montée en température de ce matériau de base peut être assurée par conduction en chauffant le creuset thermiquement ou, encore, en agissant directement sur le matériau par un bombardement au moyen d'un canon à électrons.

Les conditions opératoires données ci-dessus l'ont été en relation avec l'évaporation sous vide de l'aluminium, en vue de former, par oxydation au cours du processus de transfert, une couche d'alumine sur un substrat, à raison d'une croissance d'épaisseur de 100 nm/h. En modifiant les paramètres de conduite, tels que le vide initial, les températures et la pression partielle du milieu oxydant, le procédé de l'invention peut être conduit pour réaliser une croissance d'épaisseur plus faible ou plus élevée avec une épaisseur finale de la couche non critique pouvant aller de quelques dixièmes de nanomètre à quelques microns.

Le procédé de l'invention peut être mis en oeuvre dans les mêmes conditions, pour assurer la formation d'une couche d'alumine en partant d'un matériau de base constitué directement par l'alumine.

Dans un tel cas, les conditions opératoires peuvent être les suivantes:
- puissance d'un canon à électrons réglée pour produire une vitesse de croissance de 0,5 nm/s,
- pression partielle d'oxygène 1,3.10$^{-3}$ Pa,
- température du substrat comprise entre l'ambiante et 450°C.

A titre d'exemple, les paramètres à respecter pour la mise en oeuvre du procédé de l'invention, en vue de la constitution d'une couche isolante à partir de l'oxyde simple de silicium, sont les suivantes:

| - pression initiale | $10^{-7}$ à $10^{-6}$ Pa |
| - pression partielle du milieu oxydant | $10^{-4}$ à $2.10^{-3}$ Pa |
| - température du substrat comprise entre | l'ambiante et 300 °C |
| - température du creuset, environ | 1 250°C |
| - vitesse de croissance | 7 200 nm/h |

Le procédé de l'invention pourrait être mis en oeuvre dans le cas de constitution d'une couche isolante à partir du dioxyde de silicium, en situant la température du substrat entre l'ambiante et 450°C et en réglant la puissance appliquée à un canon à électrons dirigée sur le matériau à évaporer pour produire une vitesse de croissance de 100 nm/h dans un milieu oxydant de pression partielle de $10^{-4}$ à $2.10^{-3}$ Pa.

Le procédé de l'invention peut être qualifié de procédé de formation par dépôt par évaporation sous vide à basse température, étant donné que le substrat n'est jamais soumis à une température supérieure à 500°C. Cette température basse présente un avantage important, dans le cas notamment, où la couche isolante doit être rapportée sur un composant électronique ayant déjà subi une phase de traitement par dopage notamment. En effet, dans un tel cas, le composant n'est pas soumis à une température susceptible de perturber, modifier ou détériorer l'implantation et le profil de dopage et permet, par conséquent, de mettre en oeuvre une phase finale conduisant à l'obtention d'un produit définitif ayant exactement les caractéristiques électriques ou électroniques conférées par les phases de traitement antérieur. Ceci représente un avantage important qui ne peut pas être obtenu dans la technique actuelle où par exemple, le dépôt d'une couche isolante intervient par passage dans un four imposant au composant complet une température pouvant être de l'ordre de 1 000°C.

## Possibilités d'applications industrielles:

Le procédé selon l'invention présente un avantage non négligeable dans le même sens pour les composants électroniques constitués à base de semi-conducteurs composés, tels que l'arséniure de gallium ou le phosphure d'indium qui présentent la particularité de se décomposer par eux-mêmes en partie à partir de 400 et 300°C respectivement.

Le procédé de l'invention permet aussi d'envisager le dépôt de couches isolantes sur des couches préalables de silicium amorphe qui sont également réalisées à basses températures.

Un autre objet de l'invention réside dans le fait que le procédé permet la formation, par dépôt par évaporation sous vide ou ultra-vide, d'une couche isolante par dessus une couche conductrice ou semiconductrice formée dans la même enceinte. Ceci devient possible sans ressortir le substrat pré-traité dans l'atmosphère, ce qui supprime tout risque de pollution. Le procédé de l'invention permet de disposer, dans un tel cas, d'interfaces de couches non polluées et de bonne qualité, ce qui est une condition importante, sinon sine qua non, pour la réalisation de composants électroniques du type métal isolant semi-conducteur.

L'invention n'est pas limitée aux exemples décrits et représentés. En particulier, il peut être envisagé d'interrompre la croissance de la pré-couche en orientant différemment et de façon temporaire le substrat pendant la phase d'oxydation.

De plus, le procédé de réalisation d'une pré-couche et de son amélioration avant la croissance totale du film isolant peut être envisagé et adapté pour d'autres procédés de dépôt sous basse pression, notamment la pulvérisation ionique en général ou l'évaporation réactive activée.

## Revendications

1. Procédé de formation par dépôt sous basse pression d'une couche de matériau isolant sur un substrat du type consistant à placer le substrat dans une enceinte reliée à des moyens de création et d'entretien d'un vide relatif, à disposer dans l'enceinte une source de matériau à évaporer, à faire le vide relatif dans l'enceinte, à soumettre ledit matériau à une montée en température pour provoquer, à partir de la source, l'évaporation dudit matériau et le dépôt d'une couche isolante sur la surface du substrat orientée vers la source et à entretenir ces conditions opératoires pendant une durée déterminée pour obtenir, sur le substrat, la croissance d'une couche jusqu'à l'épaisseur désirée,

caractérisé en ce qu'il consiste à:

- établir dans l'enceinte, après chargement du substrat et du matériau, un vide au moins égal à $10^{-3}$ Pa,

- entretenir ensuite une pression partielle au moins supérieure d'une décade ou vide initial, par introduction d'un milieu oxydant pour le matériau,

- provoquer selon des paramètres stables l'évaporation du matériau pour former sur le substrat une pré-couche d'épaisseur inférieure à la couche isolante devant être obtenue,

- interposer un masque entre le matériau et le substrat tout en maintenant les mêmes conditions pour soumettre, pendant une durée déterminée, les atomes ou molécules constituant 10 pré-couche à l'influence du milieu oxydant pour parfaire leur constitution chimique et leur organisation mutuelle,

- enlever le masque pour faire croître, toujours selon les mêmes paramètres et dans le même milieu oxydant, une couche de matériau isolant sur 10 pré-couche jusqu'à l'épaisseur souhaitée.

2. Procédé selon la revendication 1, caractérisé en ce que les paramètres d'évaporation stables font intervenir un milieu oxydant constitué par deo l'oxygène, une température de substrat comprise entre l'ambiante et 450°C.

3. Procédé selon la revendication 1, caractérisé en ce qu'on forme la pré-couche sur une épaisseur comprise entre 1 et 5 nanomètres.

4. Procédé selon la revendicotion 1 ou 3, caractérisé en ce qu'il consiste à contrôler, par méthode physicochimique et après interposition du masque, l'existence éventuelle dans la pré-couche d'atomes chimiquement libres du matériau évaporé.

5. Procédé selon l'une des revendications 1, 3 ou 4, caractérisé en ce qu'on soumet la pré-couche à oxydation en la bombardant avec le flux d'un canon à ions oxydants.

6. Procédé selon la revendication 5, caractérisé en ce qu'on soumet la pré-couche à un bombardement d'ions qui provoque une érosion de la pré-couche sur la moitié de son épaisseur environ.

7. Procédé selon la revendication 6, caractérisé en ce que le bombardement d'ions est conduit de manière à laisser subsister, malgré l'érosion qui en déroule, une épaisseur minimale égale à environ 0,5 nm de la pré-couche, quelle que soit son épaisseur initiale.

8. Procédé selon la revendication 4, caractérisé en ce qu'on contrôle par spectrométrie d'électrons AUGER l'absence ou l'extrême petitesse du pic "métal" ou semi-conducteur libre et la grande amplitude du pic "oxygène".

9. Procédé selon la revendication 8, caractérisé en ce qu'on contrôle la présence de pics hautes énergies dépourvus de renflements ou de dédoublements dus aux pics caractéristiques du métal ou semi-conducteur libre.

**Patentansprüche**

Verfahren zur Herstellung einer Schicht eines isolierenden Materials auf einem Substrat durch Beschichtung unter niedrigem Druck vom Typ, bei dem das Substrat in einem Raum angeordnet wird, der mit einer Einrichtung zur Erzeugung und Beibehaltung eines relativen Vakuums verbunden ist, in dem Raum eine Quelle des zu verdampfenden Materials angeordnet ist, das relative Vakuum in dem Raum erzeugt wird, das Material einem Temperaturanstieg unterworfen wird, um ausgehend von der Quelle die Verdampfung des Materials und die Beschichtung einer isolierenden Schicht auf der Oberfläche des Substrats hervorzurufen, die auf die Quelle gerichtet ist, und die Betriebsbedingungen während einer bestimmten Dauer beibehalten werden, um auf dem Substrat das Anwachsen einer Schicht bis zur gewünschten Dicke zu erhalten, dadurch gekennzeichnet, daß:

- in dem Raum nach Beschickung des Substrats und des Materials ein Vakuum von weniger als $10^{-3}$ Pa eingerichtet wird,
- anschließend ein teilweiser Druck wenigstens um eine Dekade gegenüber dem Ausgangsdruck höher durch Einführen eines oxidierenden Milieus für das Material beibehalten wird,
- gemäß stabilen Parametern die Verdampfung des Materials hervorgerufen wird, um das Substrat auf einer Vorschicht einer Dicke zu bilden, die geringer ist als die isolierende Schicht bevor sie erhalten wird,
- eine Maske zwischen dem Material und dem Substrat unter Beibehaltung derselben Bedingungen eingebracht wird, um während einer vorbestimmten Dauer die Atome oder Moleküle, die die Vorschicht bilden dem Einfluß des oxidierenden Milieus zu unterwerfen, um ihre chemische Beschaffenheit und ihre gegensitige Organisation bzw. Anordnung zu vollenden,
- die Maske entfernt wird, um stets gemäß denselben Parametern und in demselben oxidierenden Milieu eine Schicht des isolierenden Materials auf der Vorschicht bis zu gewünschten Dicke anwachsen zu lassen.

- Verfahren nach Anspruch 1, dadurch gekennzeichnet, daß die stabilen Verdampfungsparameter ein oxidierendes Milieu hereinbringen, das durch Sauerstoff gebildet ist, bei einer Substrattemperatur zwischen Umgebungstemperatur und 450°C.

3. Verfahren nach Anspruch 1, dadurch gekennzeichnet, daß die Vorschicht mit einer Dicke von zwischen 1 und 5 Nanometern gebildet wird.

4. Verfahren nach Anspruch 1 oder 3, dadurch gekennzeichnet, daß es darin besteht, durch ein physikalischchemisches Verfahren und nach Einbringung der Maske das eventuelle Vorhandensein von chemisch freien Atomen des verdampften Materials in der Vorschicht zu steuern.

5. Verfahren nach einem der Ansprüche 1, 3 oder 4, dadurch gekennzeichnet, daß die Vorschicht der Oxidation durch Beschießen mit dem Strom von Oxidationsionen aus einer Kanone unterworfen wird.

6. Verfahren nach Anspruch 5, dadurch gekennzeichnet, daß die Vorschicht einem Beschuß von Ionen unterworfen wird, der eine Erosion der Vorschicht auf der Hälfte ihrer Dicke hervorruft.

7. Verfahren nach Anspruch 6, dadurch gekennzeichnet, daß der Ionenbeschuß derart durchgeführt wird, daß trotz der abfließenden Erosion eine minimale Dicke ungefähr gleich 0,5 nm der Vorschicht beibehalten wird, unabhängig von ihrer Ausgangsdicke.

8. Verfahren nach Anspruch 4, dadurch gekennzeichnet, daß durch Elektronenspektrometrie gemäß AUGER das Nichtvorhandensein oder die kleinste Kleinheit des Peaks "Metall" oder freier Halbleiter und die große Amplitude des Peaks "Sauerstoff" gesteuert wird.

9. Verfahren nach Anspruch 8, dadurch gekennzeichnet, daß das Vorhandensein von Peaks hoher Energie aufgrund von Verstärkungen oder Spaltungen aufgrund charakteristischer Peaks des Metalls oder des freien Halbleiters gesteuert wird.

**Claims**

1. Process of formation by deposit under low pressure of a layer of insulating material on a substrate of the type consisting in placing the substrate inside an enclosure connected to means for creating and maintaining a relative vacuum, in placing inside the enclosure a source of material to be evaporated, in creating a relative vacuum inside the enclosure, in subjecting the material to a rise in temperature in order to cause, from the source, the evaporation of said material and the deposition of an insulating layer on the surface of the substrate oriented toward the source and in maintaining these operational conditions for a predetermined period of time, in order to obtain, on the substrate, the growth of a layer until the target thickness is reached,
characterized in that it consists in :
- creating in the enclosure, after loading in the substrate and the material, a vacuum at least equal to $10^{-3}$ Pa,
- then maintaining a partial pressure greater by at least a decade, than the initial vacuum, by introducing a material-oxidizing medium,
- causing according to stable parameters the evaporation of the material in order to form on the substrate a pre-layer thinner than the insulating layer to be obtained,
- interposing a mask between the material and the substrate while maintaining the same conditions in order to subject for a predetermined duration, the atoms or molecules constituting the pre-layer to the effect of the oxidizing medium in order to perfect their chemical constitution and their mutual organisation,
- removing the mask in order to cause a layer of insulating material to grow on the prelayer, still in the same parameters and in the same oxidizing medium, until the target thickness is reached.

2. Process according to claim 1, characterized in that the stable parameters of evaporation require an oxidizing medium constituted by oxygen, and a substrate temperature ranging between ambient temperature and 450°C.

3. Process according to claim 1, characterized in that the pre-layer is formed over a thickness ranging between 1 and 5 nm.

4. Process according to claim 1 or 3, characterized in that it consists in monitoring, by the physicochemical method and after interposition of the mask, the possible existence in the pre-layer, of chemically-free atoms of the evaporated material.

5. Process according to one of claims 1, 3 or 4, characterized in that the pre-layer is subjected to oxidizing by bombarding it with the flux of an oxidizing ion gun.

6. Process according to claim 5, characterized in that the pre-layer is subjected to a bombardment of ions which causes an erosion of the pre-layer over about half of its thickness.

7. Process according to claim 6, characterized in that the bombardment of ions is conducted so as to allow to remain, despite the erosion which follows therefrom, a minimum thickness, equal to about 0 - 5 nm of the pre-layer, whatever its initial thickness.

8. Process according to claim 4, characterized in that the absence or extreme smallness of the "metal" or free semi-conductor peak and the great amplitude of the "oxygen" peak is controlled by spectrometry of AUGER electrons.

9. Process according to claim 8, characterized in that the presence of high energy peaks bereft of swells or splittings due to the peaks characteristic of the metal or free semi-conductor is controlled.

Fig_1

EP 0 197 990 B1

$10^{-19}J$

81,7

108,9

801

2066,6

2125,9

2170,7

2207,6

$P_1$

$P_2$

# Fig.2

EP 0 197 990 B1